# FASCICULE DE BREVET EUROPEEN

(11) **EP 3 084 356 B1**
(45) Date de publication et mention de la délivrance du brevet: **24.02.2021**
(21) Numéro de dépôt: 14815756.3
(22) Date de dépôt: 19.12.2014
(51) Int. Cl.: G01D 11/30, G01L 9/00

(54) **DISPOSITIF DE MESURE A CIRCUIT DE COMMANDE UNIQUE**
MESSVORRICHTUNG MIT EINER EINZELNEN STEUERUNGSSCHALTUNG
MEASUREMENT DEVICE WITH SINGLE CONTROL CIRCUIT

(30) Priorité: 19.12.2013 FR 1363052
(43) Date de publication de la demande: 26.10.2016
(73) Titulaire: Airbus Operations S.A.S., 31060 Toulouse (FR)
(72) Inventeur: DUPE, Nicolas, F-31700 Cornebarrieu (FR); SORNIQUE, Olivier, F-31770 Colomiers (FR); STUDER, Gilles, F-31470 Fonsorbes (FR)
(74) Mandataire: Gicquel, Olivier Yves Gérard
(86) Numéro de dépôt international: PCT/EP2014/078828
(87) Numéro de publication internationale: WO 2015/091996

(56) Documents cités:
- WO-A1-99/50115
- WO-A1-2006/053386
- WO-A1-2008/053193
- FR-A1- 2 953 287
- US-A- 6 134 485
- US-A1- 2006 202 086
- US-A1- 2013 141 340

## Description

La présente invention concerne un dispositif de mesure susceptible d'être accolé sur une paroi extérieure d'un objet mobile ou d'un objet fixe se trouvant dans un écoulement d'air pour mesurer des grandeurs physiques. Plus particulièrement, la présente invention s'applique à la mesure de paramètres utilisés pour caractériser un écoulement d'air à la surface d'un aéronef.

### DOMAINE TECHNIQUE

Lors d'essais en vol, des capteurs sont montés sur la surface extérieure d'un aéronef pour effectuer différents types de mesure. L'étude des résultats permet de comprendre le comportement d'un aéronef en vol et d'en améliorer ou valider les performances. Selon une application particulière, il est possible par exemple de détecter et localiser des phénomènes aérodynamiques sur l'aéronef.

### TECHNIQUE ANTERIEURE

Le brevet FR2953287 déposé par MC ACI le 27 novembre 2009 divulgue un dispositif pour conduire des mesures au voisinage d'une paroi. Le dispositif comprend une plaque polymère de faible épaisseur susceptible d'être fixée sur ladite paroi. La plaque polymère comporte des cavités aptes à recevoir des capteurs ainsi que des fils électriques débouchant dans lesdites cavités.

Chaque cavité comprend deux logements séparés par une flasque : le premier logement reçoit le capteur et le deuxième logement les moyens de connexion électriques entre le capteur et les fils électriques. Selon une forme de réalisation particulière, un troisième logement est prévu pour recevoir un circuit électronique appelé « circuit de mesure », nécessaire au fonctionnement du capteur associé.

La forme du dispositif est donc complexe au vu du nombre de logements nécessaires pour l'ensemble des capteurs, fils électriques et circuits de mesure.

De plus, il est nécessaire de souder l'extrémité des fils électriques à d'autres conducteurs électriques, de les revêtir d'un blindage en cuivre, de les associer à une plaque support et de les noyer dans une plaque polymère. Il s'en suit un système d'interconnections compliqué dans lequel il est difficile voire impossible d'intervenir en cas de panne du type par exemple rupture d'un fil électrique

Le document US20006202086 décrit un dispositif de mesure selon l'état de la technique.

La présente invention a donc pour but de pallier à tous ces inconvénients et de proposer un dispositif de mesure simple offrant un système de contrôle et d'interconnexion des capteurs accessible et moins complexe.

### EXPOSE DE l'INVENTION

Pour ce faire, la présente invention propose un dispositif de mesure comprenant un support présentant des logements pourvus d'une ouverture débouchant vers l'extérieur dans lesquels sont prévus des capteurs, caractérisé en ce que le support comprend une cavité dans laquelle est logée un circuit imprimé flexible au niveau duquel est prévu un unique circuit de commande des capteurs.

De cette manière, a présente invention en prévoyant un seul circuit de commande offre de nombreux avantages : un poids moins important, une consommation plus faible, une communication de données moins complexe, un système moins encombrant, une limitation des points de rigidité en zone courbe du fait de sa faible surface pour une longévité accrue.

L'invention prévoit au moins l'une des caractéristiques optionnelles suivantes, prises isolément ou en combinaison.

Le circuit est traversé par des pistes joignant les extrémités de liaison du circuit.

Les capteurs sont positionnés sur une même ligne ou plusieurs lignes déportée(s) par rapport aux pistes.

Des pistes sont prévues pour relier chacun des capteurs au circuit de commande.

Le circuit comporte au moins deux couches de circuit imprimé séparées par une couche isolante.

Les pistes qui traversent le circuit et les pistes prévues pour relier les capteurs au circuit de commande se trouvent sur l'une ou l'autre des couches de circuit imprimé.

L'une des pistes est réservée à l'alimentation du capteur.

La présente invention concerne également le système de mesure comprenant au moins un dispositif de mesure présentant les caractéristiques ci-dessus. Le système comprend une unité centrale d'alimentation et d'acquisition connectée au circuit imprimé flexible dudit dispositif de mesure, ladite unité comportant un circuit de commande de l'ensemble des circuits de commande des dispositifs de mesure.

Le système de mesure comprend des moyens d'alimentation de l'ensemble des dispositifs de mesure par l'intermédiaire d'une piste du circuit.

### DESCRIPTION SOMMAIRE DES DESSINS

D'autres buts, avantages et caractéristiques de l'invention apparaîtront à la lecture de la description qui va suivre du dispositif selon l'invention, donné à titre d'exemple non limitatif en référence aux dessins ci-annexés dans lesquels :
- La figure 1 représente une vue schématique en perspective et en transparence partielle d'une forme de réalisation du système global de mesure comprenant le dispositif de mesure selon la présente invention dans laquelle la jonction entre deux dispositifs de mesure est représentée schématiquement en coupe longitudinale agrandie et simplifiée partielle ;
- la figure 2 représente une vue schématique en coupe du dispositif de mesure selon la forme de réalisation représentée sur la figure 1 ;
- la figure 3 représente une vue schématique en coupe d'une autre forme de réalisation dudit dispositif selon la présente invention ;
- la figure 4 représente une vue schématique simplifiée de l'agencement de certains composants électroniques et de certaines liaisons entre lesdits composants selon une forme de réalisation du dispositif de mesure selon la présente invention ; pour des raisons de simplification, l'ensemble des composants et liaisons n'est pas représenté ;
- la figure 5 représente une vue schématique simplifiée de l'agencement de certains composants électroniques et de certaines liaisons entre lesdits composants du système global de mesure comprenant le dispositif de mesure selon une forme de réalisation de la présente invention ; pour des raisons de simplification, l'ensemble des composants et liaisons n'est pas représenté ;
- la figure 6 représente une vue schématique d'un film d'un dispositif de mesure selon la présente invention présentant un agrandissement des orifices réalisés dans ledit film ;
- la figure 7 représente une vue schématique simplifiée en perspective d'un outillage utilisé pour l'assemblage du dispositif de mesure dans laquelle une vue agrandie simplifiée en perspective montre une partie du dispositif de mesure en cours d'assemblage.

### MANIERE DE REALISER L'INVENTION

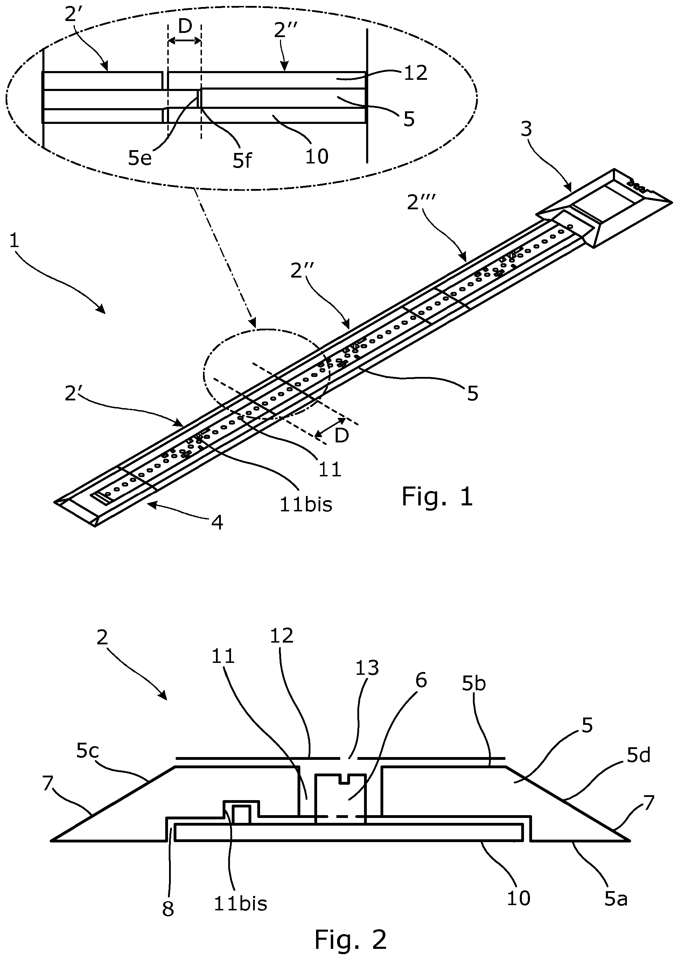

Selon une application illustrative représentée sur la figure 1, le système 1 de mesure selon la présente invention équipe une zone déterminée d'un aéronef. Le système 1 présente au moins trois parties 2, 3 et 4. La première partie 2 faisant l'objet de la présente demande de brevet consiste en un dispositif 2 de mesure de différentes grandeurs physiques susceptible d'être accolé sur une paroi à l'extérieur de l'aéronef et par exemple sur la paroi extérieure de la voilure de l'aéronef. Un système 1 de mesure peut comprendre un ou plusieurs dispositifs 2 de mesure désignés sur la figure 1 par les références 2', 2", 2"', les dispositifs 2 de mesure étant liés de manière à former une chaîne de dispositif permettant d'effectuer des mesures sur une surface étendue. La deuxième partie 3 consiste en une unité 3 centrale d'alimentation et d'acquisition des signaux en provenance dudit ou des desdits dispositifs 2 de mesure. L'unité 3 d'alimentation et d'acquisition est située soit au contact d'un dispositif de mesure soit à distance de celui-ci. La partie 4 consiste en un dispositif qui, comme la partie 2, est susceptible également de réaliser des mesures. Cependant, elle ne présente pas toutes les caractéristiques d'un dispositif 2 de mesure du fait notamment qu'elle soit placée en bout de chaîne. La partie 4 termine la chaîne des dispositifs 2 de mesure et sera appelée de ce fait dans la suite, dispositif 4 d'extrémité.

Le dispositif 2 de mesure représenté sur les figures 1 et 2 se présente sous la forme d'un support 5 de capteurs 6 souple permettant d'épouser les contours de l'aéronef. Chaque capteur est susceptible de mesurer des grandeurs physiques telles que à titre illustratif et non limitatif la pression, la température, l'accélération, les efforts mécaniques ... Les capteurs peuvent être regroupés dans des unités permettant de faire la mesure de plusieurs grandeurs et par exemple dans un microsystème électromécanique appelé MEMS. Les unités de mesure multi-grandeurs de type MEMS seront appelés dans ce qui suit capteur 6. Le support 5 a pour fonction d'offrir un carénage aux capteurs ne nécessitant de ce fait aucune enveloppe particulière et de maintenir les capteurs au plus près de la paroi sur laquelle le dispositif de mesure est disposé pour effectuer les mesures. Le support peut être réalisé en matériau polymère par exemple en polyuréthane ou silicone souple pour épouser les contours de l'aéronef. Il peut être réalisé par moulage, usinage ou tout autre procédé de fabrication connu.

Le support 5 peut présenter tout type de forme. Dans l'exemple illustré, le support présente une forme longiligne parallélépipédique de section transversale trapézoïdale. Comme indiqué, le support 5 peut se présenter sous une autre forme et ne pas être longiligne, ni même parallélépipédique. Les capteurs 6 sont logés dans la partie centrale du support de plus grande épaisseur. Le support 5 présente six faces :
- une première face 5a destinée à venir en contact avec la paroi de l'aéronef ;
- une deuxième face 5b libre, parallèle et opposée à la face 5a ;
- deux faces 5c, 5d formant les bords 7 du support 5. Les bords 7 du support 5 présentent une épaisseur décroissante permettant d'offrir une surface perturbant très faiblement l'écoulement aérodynamique ;
- deux faces 5e, 5f non représentées sur les figures, de forme trapézoïdale formant les extrémités du support, l'une d'entre elle étant destinée à se connecter aux liaisons prévues vers l'unité 3 d'alimentation et d'acquisition ou à un autre dispositif 2 de mesure et l'autre étant destinée à se connecter à un autre dispositif 2 de mesure ou à un dispositif 4 d'extrémité. Selon une forme de réalisation possible, les faces 5e et 5f sont parallèles entre elles ; les faces 5e et 5f sont également orthogonales aux faces 5a et 5b. De cette manière, les dispositifs de mesure peuvent être accolés par leurs faces 5e et 5f pour former un support 5 global homogène et continu. Comme indiqué plus haut, le support 5 peut présenter tout type de forme : ainsi, les faces 5e et 5f peuvent ne pas être planes mais chanfreinées ou encore par exemple présenter une forme complexe. La forme de la face respectivement 5e, 5f doit être telle qu'elle s'emboite dans la forme de la face respectivement 5f, 5e du support 5 du dispositif de mesure adjacent de manière à former une chaîne de support homogène et sans discontinuité.

Le système 1 de mesure comprend successivement l'unité 3 d'alimentation et d'acquisition, un ou plusieurs dispositifs 2'-2'" de mesure et un dispositif 4 d'extrémité. Le support 5 du dispositif 4 d'extrémité peut présenter la même forme que celui d'un dispositif de mesure 2 à l'exception de la face 5f libre. En effet, le dispositif 4 d'extrémité étant le dispositif de mesure placé à l'extrémité d'une chaine de dispositif 2 de mesure d'un système 1, l'une des faces du dispositif 4 d'extrémité n'est pas accolée à un autre dispositif de mesure et reste libre. Elle présente une épaisseur décroissante pour former avec la paroi extérieure contre laquelle le dispositif 4 est appliqué un profil le plus aérodynamique possible. Le dispositif 4 d'extrémité comprend des impédances de bout de ligne permettant d'assurer la terminaison de la ligne électrique réalisée par la succession de dispositif de mesure.

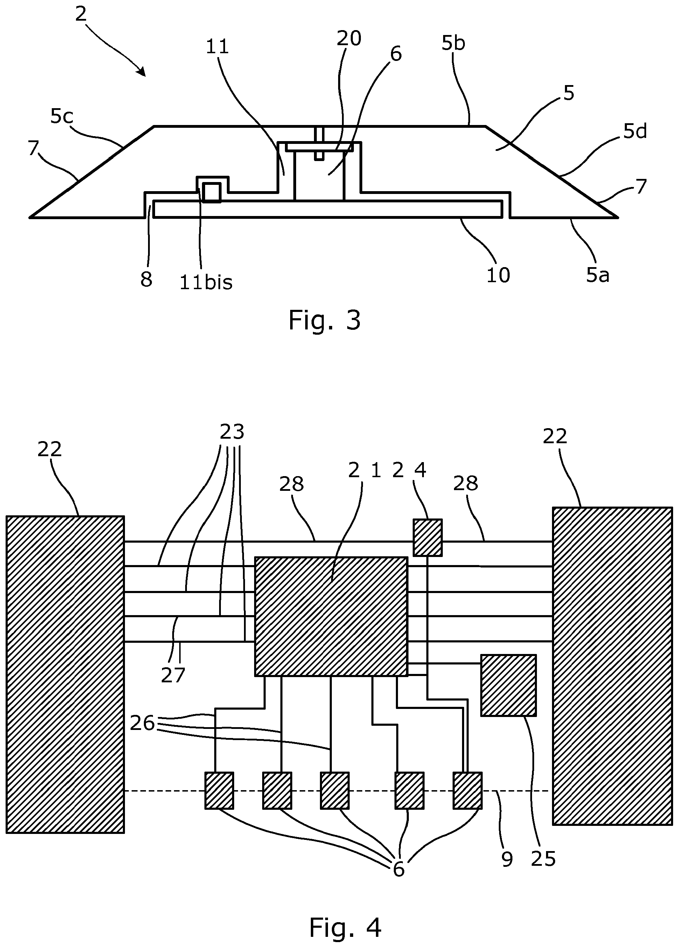

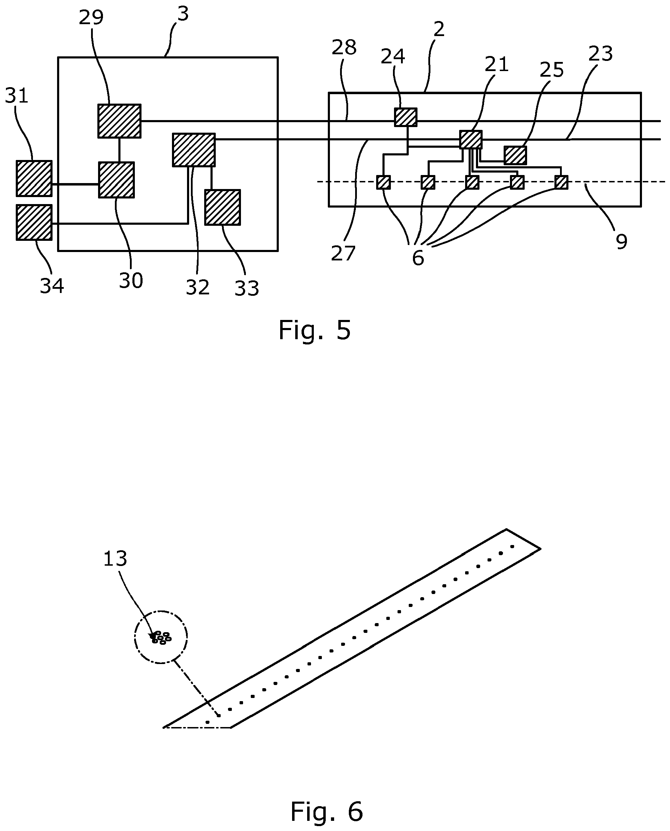

Le support 5 peut recevoir une pluralité de capteurs 6. Dans la forme de réalisation illustrée sur la figure 2, les capteurs 6 sont répartis de manière homogène ou pas sur toute ou partie de la longueur du support 5. Selon une forme de réalisation de l'invention, les capteurs 6 sont répartis de manière homogène. Chaque capteur 6 est séparé du capteur voisin d'une distance évitant toute interférence dans leur fonctionnement. Comme représenté sur les figures 4 et 5, les capteurs 6 sont par exemple disposés sur une même ligne 9 parallèle à la direction longitudinale du support 5. Les capteurs pourraient être disposés selon un autre arrangement et par exemple sur plusieurs lignes parallèles entre elles.

Comme illustré sur les figures 1 et 2, le support 5 présente une cavité 8 réalisée au niveau de la face 5a destinée à être en contact avec la paroi de l'aéronef. La cavité 8 reçoit un circuit 10 imprimé flexible (communément appelé flex PCB de l'anglais Printed Circuit Board ou encore circuit flex). La cavité 8 présente une forme correspondant à celle du circuit 10 et épouse les formes de ce circuit. Dans l'exemple illustré, le circuit 10 présente une forme longiligne en adéquation avec celle du support 5. Le circuit pourrait présenter tout autre type de forme. Dans les dispositifs de mesure 2 en dehors du dispositif 4 d'extrémité, le circuit 10 débouche de chaque côté du support 5 pour permettre la connexion d'une part avec l'unité 3 d'alimentation et d'acquisition centrale ou un autre dispositif 2 de mesure et d'autre part avec un autre dispositif 2 de mesure ou le dispositif 4 d'extrémité comme vu plus haut. Le circuit 10 et le support 5 suivent une même direction longitudinale. L'épaisseur de la cavité 8 est telle que la surface libre du circuit 10 affleure la surface du support 5 destinée à venir en contact avec la paroi de l'aéronef. De cette manière, le support 5 et le circuit 10 forme une même surface lisse et souple permettant d'adhérer au mieux au profil de la zone de l'aéronef sur laquelle ladite surface est destinée à être accolée. Selon une forme de réalisation illustrée sur la figure 1, le circuit 10 que l'on voit en transparence ou en détail sur la vue en coupe longitudinale simplifiée agrandie pour le dispositif 2", dépasse d'une certaine distance D de l'extrémité 5f du support 5 : une partie du circuit 10 se trouve donc à l'extérieur du support 5 sans contact avec celui-ci. L'autre extrémité du circuit 10 est décalée d'une certaine distance et par exemple de la même distance D de l'autre extrémité 5e du support ; la figure 1 le montre pour le dispositif 2' adjacent. De cette manière, les dispositifs 2 de mesure peuvent s'emboiter les uns dans les autres, l'extrémité du circuit 10 se trouvant à l'extérieur du support 5 du dispositif 2" venant s'insérer dans l'espace laissé libre par le décalage du circuit 10 se trouvant dans le support 5 du dispositif 2' voisin. Les distances D du décalage à une extrémité et à l'autre du support 5 peuvent être identiques ou différentes.

Selon une première forme de réalisation de l'invention, celle illustrée sur la figure 2, le support 5 présente des logements 11 pour les capteurs 6, la forme de chacun de ces logements 11 correspondant à celle des capteurs 6 y logeant. Chaque logement 11 épouse les contours du capteur 6 qui lui est destiné. Chaque logement 11 débouche vers l'extérieur du support, à savoir au niveau de la face 5b du support 5. Chaque logement 11 débouche également au niveau de la cavité 8 pour permettre au capteur 6 d'être en connexion avec le circuit 10 et dans la forme de réalisation illustré, d'être soudé au circuit 10. La hauteur du logement 11 est telle que le capteur 6 ne soit pas en contact avec le film 12.

Le logement 11 est fermé par un film 12. Le film 12 d'une seule pièce recouvre tous les logements 11 du dispositif 2 de mesure. Selon la forme de réalisation illustrée sur la figure 2, le film 12 présente des dimensions telles qu'il recouvre la totalité de la surface de la face 5b du support dans le sens transversal. Selon une autre forme de réalisation, le film 12 s'étend sur une partie seulement de la surface de la face 5b dans le sens transversal. La largeur du film 12 doit être inférieure ou égale à la largeur de la face 5b du support. Comme représentée de manière simplifiée sur la figure 1 pour le dispositif 2" de mesure, dans la direction longitudinale du support, au niveau de l'extrémité 5f, le film 12 dépasse d'une certaine distance D de l'extrémité 5f du support 5 : une partie du film 12 se trouve donc à l'extérieur du support 12 sans contact avec celui-ci. L'autre extrémité du film 12 est décalée d'une certaine distance et par exemple de la même distance D de l'autre extrémité 5e du support ; la figure 1 le montre pour le support 5 du dispositif 2' adjacent. De cette manière, les dispositifs de mesure peuvent s'emboiter les uns dans les autres, l'extrémité du film 12 se trouvant à l'extérieur du support 5 venant reposer sur la surface laissée libre par le décalage du film 12 se trouvant sur le support 5 du dispositif 2' voisin. Les distances D du décalage à une extrémité et à l'autre du support 5 peuvent être identiques ou différentes. En effet, le dispositif 4 d'extrémité ne comprend pas de film 12 propre. Il est recouvert par le film 12 qui dépasse du dispositif 2 de mesure adjacent. Il peut donc être nécessaire d'avoir une longueur plus longue de film 12 sur un dispositif 2 de mesure adjacent au dispositif 4 d'extrémité. Il en est de même pour le circuit 10 comme vu plus haut. Selon une forme de réalisation particulière, le film 12, le support 5 et le circuit 10 présente une longueur identique et la distance D pour le film et le circuit est identique. Ces distances pourraient être différentes. Dans l'exemple illustré, le film 12 présente une forme longiligne parallélépipédique. La largeur du film 12 est identique à la largeur de la face 5b libre du support. Le film 12 peut présenter comme vu plus haut une largeur inférieure.

L'épaisseur du film dépend du matériau adopté. Le matériau et l'épaisseur du film doivent être tels que le film soit suffisamment souple pour suivre les contours de l'avion. Il peut par exemple se présenter sous la forme d'un clinquant métallique ou polyuréthane d'une épaisseur comprise entre 0,01 et 0,5 millimètre et dans l'exemple illustré de 0,05 millimètre. Le film 12 est intégré à la forme du support 5. Dans le cas d'un clinquant métallique, il n'offre aucune aspérité, aucun relief susceptible de venir perturber l'écoulement de l'air. Le film 12 est fixé au support 5 par une colle spécifique, par un film adhésif double face ou par tout autre moyen. Le moyen de fixation est choisi de manière à isoler à l'air la liaison entre le support 5 et le film 12 : de ce fait, l'air ne peut pas passer d'un logement 11 à un autre. Les logements 11 sont isolés en air les uns des autres par le moyen de fixation introduit entre le support 5 et le film 12. De plus, le moyen de fixation peut être par exemple du ruban à transfert d'adhésif acrylique de la société 3M. Selon une forme de réalisation particulière, il est choisi un ruban de référence 9460PC et d'épaisseur 0,05 millimètre ou encore de référence 9469PC et d'épaisseur 0,13 millimètre. Dans la forme de réalisation illustrée, le film 12 repose sur le support 5. Il pourrait être intégré de multiples autres manières tout en conservant un profil le plus aérodynamique possible. Ainsi par exemple, de la même manière que pour le circuit 10, une cavité pourrait être prévue dans le support 5 dans laquelle s'insère le film 12 de manière que la surface libre du film 12 affleure avec celle du support 5. Selon une autre forme de réalisation, le film 12 d'un seul tenant pourrait recouvrir l'ensemble des dispositifs de mesure d'une chaîne de dispositifs d'un système. Dans ce dernier cas, il est également possible alors de prévoir un seul et unique support 5 de très grande longueur pour le dispositif de mesure.

Comme illustré sur la figure 2, le film 12 présente au moins un orifice 13 au droit de chaque capteur 6 assurant la prise de pression nécessaire à certains types de capteurs et permettant un passage d'air entre l'écoulement d'air extérieur au dispositif 2 se trouvant au voisinage de la paroi sur laquelle il est accolé et le capteur. En effet, certains capteurs comme par exemple le capteur de pression nécessitent des ouvertures vers l'écoulement d'air leur permettant de capter la différence de pression générée par l'écoulement. Ces ouvertures constituent des prises de pression. Les orifices 13 sont répartis sur le film 12 de la même façon que les capteurs 6 de manière que chaque capteur dispose d'au moins une prise de pression correctement positionnée et par exemple au droit de celui-ci pour lui permettre de réaliser ses mesures.

Le film 12 assure au dispositif 2 de mesure une forme aérodynamique ; il doit assurer également l'étanchéité des capteurs sans qu'il ne soit nécessaire d'ajouter des joints. Pour ce faire, dans le cas où sont prévus des prises de pression sur le film 12, chacun des orifices 13 doit présenter une taille telle que l'orifice laisse passer l'air tout en restant étanche aux fluides susceptibles d'être présents dans l'environnement dudit dispositif et de l'endommager. Par exemple dans l'application illustrée, l'orifice présente des dimensions permettant de rendre le film 12 étanche à l'eau pouvant provenir d'intempéries et/ou à un mélange d'eau et de gouttes de carburant pouvant reposer sur le dispositif de mesure. Dans l'exemple illustré sur la figure 1, les orifices 13 sont de forme circulaire et présentent par exemple un diamètre de 0,2 millimètres.

Dans une autre forme de réalisation de l'invention, le film est percé de plusieurs orifices 13 au droit de chacun des capteurs 6. Selon un exemple illustré sur la figure 6, les orifices 13 sont au nombre de 7 avec un diamètre par exemple de 0,2 millimètre. Six des sept orifices sont répartis de manière homogène sur un cercle par exemple de 0,6 millimètre de diamètre, le septième orifice se trouvant au centre de ce cercle.

Dans le cas où le film 12 adhère au support 5 par l'intermédiaire d'un film adhésif double face, le film adhésif est perforé de manière à présenter des orifices se trouvant en correspondance avec les prises de pression de telle manière que le film adhésif n'obture pas les orifices 13 du film 12.

Comme il sera vu plus loin, d'autres composants électroniques peuvent être soudés au circuit 10. Certains de ces composants peuvent être en saillie par rapport à la surface du circuit 10 de la même manière que le capteur 6. Dans ce cas, d'autres logements sont prévus dans le support 5 pour loger ces composants dans le support 5 et éviter qu'il ne le déforme. La figure 2 illustre un exemple d'un autre composant électronique dépassant de la surface du circuit 10 pour lequel un autre logement 11 bis est prévu dans le support 5. Le logement 11bis peut être débouchant à l'extérieur du support 5 (comme le montre en transparence la figure 1) ou pas (comme le logement 11bis de la figure 2) suivant la hauteur du composant électronique. Dans le cas de logements 11bis débouchant, le logement est comblé de colle pour assurer une continuité avec la surface 5b et offrir une surface 5b aussi lisse que possible pour ne pas perturber l'écoulement extérieur. Selon une forme de réalisation de l'invention, le film 12 recouvre également les logements 11bis. Dans cette forme de réalisation, les logements 11bis sont également comblés de colle pour ne pas avoir d'air emprisonné qui pourrait déformer le film 12. De plus, comme vu plus haut, la colle assure une continuité à la surface 5b qui facilité et améliore la fixation du film 12.

Selon une forme de réalisation de l'invention, les différents composants du dispositif de mesure sont assemblés de la manière suivante :
Les capteurs 6 sont fixés, dans l'exemple illustré soudés sur le circuit 10. L'ensemble formé par le circuit 10 et les capteurs 6 est ensuite fixé par tout type de moyen connu au support 5, le circuit 10 et les capteurs 6 ainsi que les autres composants électroniques mentionnés plus haut se logeant dans les cavités 8 et logements 11, 11bis prévus à cet effet. Le circuit 10 est fixé au support 5 par une colle spécifique, par un film adhésif double face ou par tout autre moyen. Le moyen de fixation est choisi de manière à isoler à l'air la liaison entre le support 5 et le circuit 10 : de ce fait, l'air ne peut pas passer d'un logement 11 à un autre.

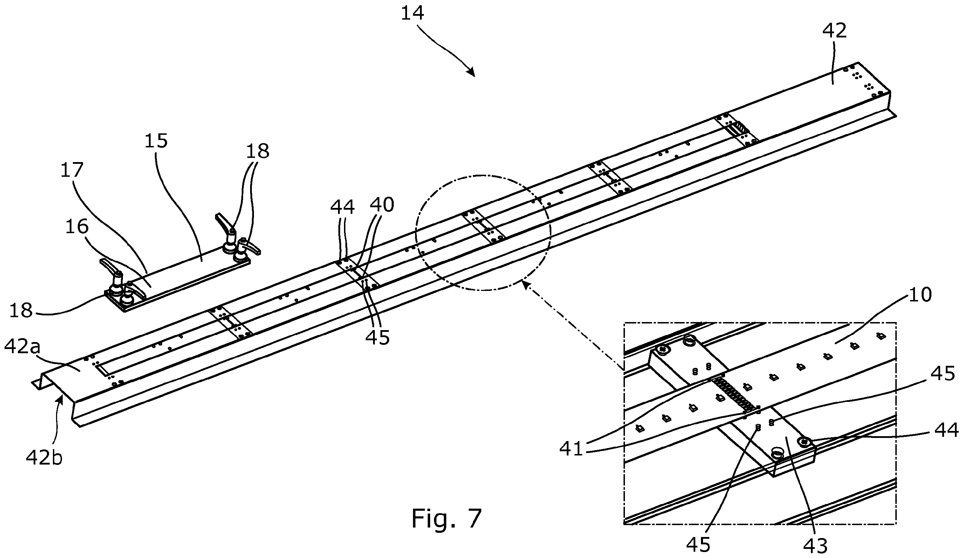

Selon un exemple de réalisation illustré sur la figure 7, le circuit 10 comporte à chacune de ses extrémités des repères de positionnement formant également des moyens de fixation sous la forme d'ouvertures 40 permettant de recevoir des moyens de fixation amovibles 41 sous la forme de tenons permettant de le fixer sur une surface 42 de support. La surface 42 de support comme montré sur la figure 7 présente une forme telle qu'elle maintient un espace entre la surface 42 de support du circuit 10 et le sol sur lequel elle est posée. Dans l'exemple illustré, la surface 42 de support présente une forme de chapeau ou en oméga. De ce fait, elle présente une surface 42a externe et une surface 42b interne. Des trous sont prévus sur cette surface de support pour permettre aux moyens 41 de fixation se présentant sous la forme de tenons de traverser celle-ci. Dans l'exemple illustré, un bloc 43 sur lequel sont intégrés des tenons 41 est fixé à la surface 42b interne, les tenons 41 du bloc 43 traversant les trous prévus sur la surface de support 42. Le bloc 43 est fixé à la surface de support par tout type de moyens connus et par exemple des moyens du type vis/écrou 44. Les tenons 41 du bloc 43 permettent le positionnement et la fixation du circuit 10 comme montré sur la figure 1. Le circuit 10 est positionné sur la surface de support à l'aide des tenons 41 du bloc 43 sur lesquels viennent se placer les ouvertures 40 du circuit 10. L'étape suivante comprend le positionnement du support 5 sur le circuit 10. Le support 5 comprend des repères de positionnement formant également des moyens pour fixer le support 5 sur le circuit 10 sous la forme d'ouvertures non représentées pratiquées dans le support 5. Les tenons 41 du bloc 43 sont placés de manière à se trouver au droit desdites ouvertures Ainsi, pour coller le circuit 10 dans le support 5, il suffit de placer les ouvertures prévues sur le support 5 au droit des tenons 41 puis d'insérer les tenons dans celles-ci. Le circuit 10 se trouve ainsi correctement positionné par rapport au support 5.

Selon une forme de réalisation particulière, la mise en place du film 12 sur le support 5 auquel est associé le circuit 10 est réalisée à l'aide d'un outil 14 représenté sur la figure 7. L'outil 14 comprend une plaque 15 présentant deux faces, une face 16 de préhension et une face 17 de travail. La face 16 de préhension est pourvue d'au moins une poignée 18 permettant de tenir et manipuler la plaque 15. Dans l'exemple illustré, la poignée se présente sous la forme de quatre bras 18 disposés à chaque coin de la plaque 15. Chacun de ces bras 18 est coudé pour faciliter la préhension de l'outil. La plaque 15 présente de préférence une taille au moins égale à celle du film 12. Aux quatre coins de la face 17 de travail de la plaque 15 se trouve des tenons non représentés. Le film 12 comprend des repères de positionnement formant des moyens pour fixer le film sur le support 5 sous la forme de trous non représentés. Les tenons sont positionnés de manière à traverser les trous prévus dans le film 12 et également des trous prévus dans le support 5. Les tenons de l'outil 14 sont engagés dans les trous prévus sur le film 12 et d'une taille telle que le film 12 reste accroché à l'outil 14 lors de sa manipulation. Le film 12 est alors enduit d'une colle, d'un film adhésif double face ou de tout autre moyen de fixation. L'outil est positionné au-dessus du support 5 de manière à engager les tenons dans les ouvertures prévues dans le support 5. Une fois que le film 12 repose sur le support 5 et y adhère, l'outil est retiré. De cette manière, le film 12 est correctement placé sur le support 5 : les orifices 13 se trouvent au droit des capteurs 6 et le film 12 ne dépasse pas transversalement de la surface 5b.

Les moyens de fixation formant repères sur la surface de support, le film, le support et l'outil peuvent présenter toute autre forme connue permettant d'assurer le positionnement et la fixation des éléments les uns avec les autres.

Le film 12 permet d'offrir une surface libre aussi lisse que possible présentant une très faible rugosité sans aucune irrégularité. Il permet d'assurer l'étanchéité des capteurs ainsi que l'isolation en air entre tous les capteurs du support.

Les capteurs 6 se trouvent enveloppés par les parois du support 5, du circuit 10 et du film 12.

Selon une seconde forme de réalisation illustrée sur la figure 2, seule la forme du film 12 diffère ; hormis le film 12, le dispositif de mesure présente l'ensemble des caractéristiques décrites pour la première forme de réalisation. Dans la deuxième forme de réalisation, le film 12 est intégré au support 5. Le film 12 et le support 5 forment une seule et même pièce. Le film 12 ne se distinguant plus du support 5, il forme une partie de ce dernier. Tout ce qui concerne les orifices pratiqués sur le film 12 est valable pour un film intégré. De ce fait, la partie intégré du support 5 formant le film 12 est désigné par le terme film 12.

Quel que soit la forme de réalisation pour un film 12 intégré ou pas au support 5, il se peut que de la condensation se forme dans le logement 11 du fait de la présence des orifices 13.

Ainsi, afin de sécuriser l'étanchéité complète des capteurs, il est possible d'intercaler une membrane 20 entre le film 12 et le capteur 6. La membrane 20 est réalisée dans un matériau laissant passer l'air pour les capteurs nécessitant une prise de pression et étanche à l'eau. La membrane peut être réalisée par exemple en matériau Gore-Tex (déposé à titre de marque). La membrane 20 peut être introduite dans chaque logement 11 et présenter les mêmes dimensions que celui-ci. Afin d'assurer l'étanchéité des capteurs, la périphérie complète de la surface de la membrane 20 faisant face au capteur 6 est collée au capteur 6 et/ou la périphérie complète de la surface de la membrane 20 faisant face au film 12 est collée au film12. La membrane 20 peut se présenter sous d'autres formes de réalisation comme par exemple sous la forme d'une bande permettant de recouvrir l'ensemble des capteurs 6 et par exemple sous la forme d'une bande rectangulaire de largeur identique à celui du logement 11 et de longueur suffisamment importante pour couvrir l'ensemble des logements 11. La membrane 20 peut par exemple présenter la même longueur que le support 5. Un espace est alors réalisé dans le support 5 pour le passage de la bande d'un logement 11 à un autre. Pour assurer l'isolation en air entre capteurs, la surface complète des deux faces opposées de la bande sont collées au support 5 dans l'espace créé.

Le circuit 10 imprimé flexible, illustré sur la figure 4, réalise la connexion assurant l'alimentation et la circulation des données notamment entre les capteurs 6, des moyens 21 de commande de ces capteurs 6, les extrémités 22 du circuit 10 au niveau desquelles se trouvent les connexions vers l'unité centrale 3 d'alimentation et d'acquisition et/ou vers d'autres dispositifs de mesures.

Comme le montrent les figures 4 et 5, des pistes 23 sont prévues dans le circuit 10. Les pistes 23 traversent de part en part le circuit 10. Les pistes 23 s'étendent entre les extrémités du support 5 pour la liaison vers l'unité centrale d'acquisition et/ou vers d'autres dispositifs de mesure.

Le circuit 10 comprend des plages d'accueil sur lesquels sont soudés les composants électroniques tels que les capteurs, les moyens 21 de commande ou autres. Seuls les composants électroniques essentiels sont représentés. D'autres composants électroniques secondaires tels que par exemple des circuits 24 régulateurs de tension, des mémoires 25 comme par exemple des mémoires EEPROM sont intégrés ou connectés au circuit 10.

Les moyens 21 de commande consiste dans la présente invention en un unique circuit intégré FPGA (en anglais field-programmable gâte array). Un seul circuit 21 intégré est prévu par dispositif 2 de mesure. Contrairement à l'art antérieur dans lequel chaque capteur disposait d'un circuit électronique propre, la présente invention prévoit un seul circuit 21 de commande offrant ainsi de nombreux avantages : un poids moins important, une consommation plus faible, une communication de données moins complexe, un système moins encombrant, une limitation des points de rigidité en zone courbe du fait de sa faible surface pour une longévité accrue. Le circuit 21 intégré FPGA contrôle l'ensemble des capteurs, récupère les données provenant de ceux-ci et les envoie via les pistes 23 à l'unité centrale d'acquisition ou à un autre dispositif de mesure. Le circuit 21 intégré est directement connecté aux pistes 23. Selon une forme de réalisation, le circuit 21 intégré se trouve sur le chemin des pistes 23. Compte-tenu du nombre de connexions nécessaires vers les différents composants du dispositif de mesure et en particulier vers les différents capteurs 6, le circuit 10 comporte plusieurs couches de circuit imprimé séparés par des couches isolantes. Sur chaque couche de circuit imprimé, sont prévus des pistes 23. Le circuit 21 intégré est connecté à des pistes 23 des différentes couches.

Les capteurs 6 sont répartis sur le circuit 10 et selon une forme de réalisation possible, déportés en dehors des pistes 23. Des plages d'accueil sont prévues offrant des points de connexion sur lesquels sont soudés les points de connexion électriques des capteurs. Des pistes 26 relient lesdits points de connexion du capteur 6 au circuit 21 intégré. Les pistes 26 peuvent également se trouver sur différentes couches du circuit imprimé.

Le circuit intégré 21 FPGA est connecté à une mémoire 25 EEPROM pour stocker des données nécessaires au fonctionnement du dispositif 2 de mesure et notamment par exemple des données d'étalonnage comme des coefficients de compensation en température des capteurs 6.

Les pistes 23 comprennent des pistes 27 permettant la communication des données et une piste 28 permettant l'alimentation de composants électroniques du dispositif de mesure. Le circuit 21 est connecté aux pistes 27. Le circuit 21 et les capteurs 6 sont connectés à la piste 28 par l'intermédiaire d'un régulateur 24 de tension. Selon une forme de réalisation de l'invention, pour adjoindre deux dispositifs de mesure ou un dispositif de mesure avec l'unité centrale d'alimentation et d'acquisition, les faces 5e, 5f du support 5 sont collées entre elles et les pistes 23 sont jointes par soudure : des plages sont prévues au niveau des extrémités 22 et plus précisément une plage par piste 23.

La figure 5 montre un schéma simplifié selon une forme de réalisation de l'invention de certains composants et de certaines liaisons électriques essentielles entre une unité centrale 3 d'alimentation et d'acquisition et un dispositif 2 de mesure.

L'unité 3 centrale d'alimentation et d'acquisition comprend des moyens 29 d'alimentation de l'ensemble des dispositifs de mesure par l'intermédiaire de la piste 28. Les circuits 21 et capteurs 6 sont connectés auxdits moyens 29 par l'intermédiaire du régulateur 24 de tension se trouvant en connexion avec la piste 28. L'unité 3 comprend également au moins un convertisseur 30 permettant de modifier l'alimentation provenant d'une source 31 extérieure, dans l'application illustré provenant de l'aéronef et permettant de l'adapter à l'alimentation requise pour les composants de l'unité 3 et des dispositifs 2 de mesure. L'unité 3 comprend également des moyens 32 de commande centrale de l'ensemble des circuits 21 ; les moyens 32 peuvent se présenter sous la forme d'un circuit FPGA. Les moyens 32 disposent d'une mémoire 33 telle qu'une mémoire EEPROM pour stocker les données nécessaires à son fonctionnement. Les moyens 32 reçoivent notamment les mesures réalisées par les dispositifs de mesure et les renvoient vers une unité 34 de collecte et/ou traitement de données pouvant se trouver dans l'exemple illustré à l'intérieur ou à l'extérieur de l'aéronef ou au sol.

Aucun moyen de commande n'est prévu dans le dispositif 4 d'extrémité. En effet comme vu plus haut, le circuit 10 dépasse du support 5 du dispositif 2 de mesure. Le circuit 10 du dispositif 2 de mesure adjacent au dispositif 4 d'extrémité vient donc s'insérer dans le support 5 du dispositif d'extrémité. Les mesures réalisées par les capteurs du dispositif 4 sont en fait celles réalisées par le dispositif 2 de mesure adjacent.

La présente invention ne se limite pas au domaine aéronautique. Le dispositif de mesure selon la présente invention pourrait être utilisé dans bien d'autres domaines techniques et par exemple dans le domaine de véhicules spatiaux, aériens, terrestres ou maritimes. Il peut également être utilisé sur un objet fixe placé dans un écoulement d'air comme par exemple une partie d'un véhicule testé en soufflerie. Il peut également servir à caractériser une soufflerie en accolant le dispositif de mesure sur une ou plusieurs parois de celle-ci.

## Revendications

1. Dispositif de mesure susceptible d'être accolé sur une paroi extérieure d'un objet mobile ou d'un objet fixe se trouvant dans un écoulement comprenant un support (5) présentant des logements (11) pourvus d'une ouverture débouchant vers l'extérieur au niveau de la face (5b) libre du support (5) dans lesquels sont logés des capteurs (6), **caractérisé en ce que** le support (5) comprend une cavité (8) réalisée au niveau de la face (5a) du support destinée à venir en contact avec la dite paroi extérieure et opposée à la face (5b) dans laquelle débouchent les logements (11) et dans laquelle est logée un circuit (10) imprimé flexible au niveau duquel est prévu un unique circuit (21) de commande des capteurs (6), le circuit (10) imprimé comprenant le circuit (21) de commande et les capteurs (6).

2. Dispositif de mesure selon la revendication 1, **caractérisé en ce que** le circuit (10) contrôle l'ensemble des capteurs (6), récupère les données provenant de ceux-ci et les envoie à des pistes (23).

3. Dispositif de mesure selon la revendication 2, **caractérisé en ce que** le circuit (10) est traversé par les pistes (23) joignant les extrémités (22) de liaison du circuit (10).

4. Dispositif de mesure selon la revendication 3, **caractérisé en ce que** les capteurs (6) sont positionnés sur une même ligne ou plusieurs lignes déportée(s) par rapport aux pistes (23).

5. Dispositif de mesure selon l'une des revendications 1 à 4, **caractérisé en ce que** des pistes (26) sont prévus pour relier chacun des capteurs (6) au circuit (21) de commande.

6. Dispositif de mesure selon l'une des revendications 1 à 5 **caractérisé en ce que** le circuit (10) comporte au moins deux couches de circuit imprimé séparées par une couche isolante.

7. Dispositif de mesure selon les revendications 2, 5 et 6, **caractérisé en ce que** les pistes (23) et (26) se trouvent sur l'une ou l'autre des couches de circuit imprimé.

8. Dispositif de mesure selon l'une des revendications 2 à 4, caractérisé en ce l'une des pistes (23) est réservée à l'alimentation des capteurs (6).

9. Système de mesure comprenant au moins un dispositif de mesure selon l'une des revendications 1 à 8, **caractérisé en ce qu'**il comprend une unité (3) centrale d'alimentation et d'acquisition connectée au circuit (10) imprimé flexible dudit dispositif de mesure, ladite unité (3) comportant un circuit (32) de commande de l'ensemble des circuits (21) de commande des dispositifs de mesure.

10. Système de mesure selon la revendication 9, caractérisé en ce le circuit (21) envoie des données à l'unité (3) ou à un autre dispositif de mesure.

## Patentansprüche

1. Messvorrichtung, die an einer Außenwand eines beweglichen Objekts oder eines feststehenden Objekts, das sich in einer Strömung befindet, angebracht werden kann, beinhaltend einen Träger (5), der Aufnahmen (11) aufweist, die auf der freien Seite (5b) des Trägers (5) mit einer nach außen mündenden Öffnung versehen sind und in denen Sensoren (6) untergebracht sind, **dadurch gekennzeichnet, dass** der Träger (5) einen Hohlraum (8) beinhaltet, der auf der Seite (5a) des Trägers, die dazu bestimmt ist, mit der Außenwand in Kontakt zu kommen, und die der Seite (5b), auf der die Aufnahmen (11) münden, entgegengesetzt ist, eingebracht ist und in dem eine flexible gedruckte Schaltung (10) untergebracht ist, in der eine einzige Schaltung (21) zur Steuerung der Sensoren (6) vorgesehen ist, wobei die gedruckte Schaltung (10) die Steuerungsschaltung (21) und die Sensoren (6) beinhaltet.

2. Messvorrichtung nach Anspruch 1, **dadurch gekennzeichnet, dass** die Schaltung (10) alle Sensoren (6) steuert, die von diesen stammenden Daten sammelt und sie an Leiterbahnen (23) weiterleitet.

3. Messvorrichtung nach Anspruch 2, **dadurch gekennzeichnet, dass** die Schaltung (10) von den Leiterbahnen (23) durchquert wird, die die Verbindungsenden (22) der Schaltung (10) zusammenführen.

4. Messvorrichtung nach Anspruch 3, **dadurch gekennzeichnet, dass** die Sensoren (6) in einer Reihe oder in mehreren Reihen, die mit Bezug auf die Leiterbahnen (23) versetzt sind, angeordnet sind.

5. Messvorrichtung nach einem der Ansprüche 1 bis 4, **dadurch gekennzeichnet, dass** Leiterbahnen (26) vorgesehen sind, um jeden der Sensoren (6) mit der Steuerungsschaltung (21) zu verbinden.

6. Messvorrichtung nach einem der Ansprüche 1 bis 5, **dadurch gekennzeichnet, dass** die Schaltung (10) mindestens zwei gedruckte Schaltungsschichten umfasst, die durch eine Isolierschicht getrennt sind.

7. Messvorrichtung nach den Ansprüche 2, 5 und 6, **dadurch gekennzeichnet, dass** sich die Leiterbahnen (23) und (26) auf der einen oder der anderen der gedruckten Schaltungsschichten befinden.

8. Messvorrichtung nach einem der Ansprüche 2 bis 4, **dadurch gekennzeichnet, dass** eine der Leiterbahnen (23) für die Stromversorgung der Sensoren (6) reserviert ist.

9. Messsystem, das mindestens eine Messvorrichtung nach einem der Ansprüche 1 bis 8 beinhaltet, **dadurch gekennzeichnet, dass** es eine zentrale Stromversorgungs- und Erfassungseinheit (3) umfasst, die mit der flexiblen gedruckten Schaltung (10) der Messvorrichtung verbunden ist, wobei die Einheit (3) eine Steuerungsschaltung (32) für alle Steuerungsschaltungen (21) der Messvorrichtungen umfasst.

10. Messsystem nach Anspruch 9, **dadurch gekennzeichnet, dass** die Schaltung (21) Daten an die Einheit (3) oder an eine andere Messvorrichtung weiterleitet.

## Claims

1. Measurement device that can be attached to an outer wall of a mobile object or of a fixed object located in a flow comprising a support (5) having recesses (11) provided with an opening emerging outwards at the free face (5b) of the support (5) in which sensors (6) are housed, **characterized in that** the support (5) comprises a cavity (8) produced on the face (5a) of the support intended to come into contact with said outer wall and opposite the face (5b) in which the recesses (11) emerge and in which is housed a flexible printed circuit (10) on which there is provided a single control circuit (21) for the sensors (6), the printed circuit (10) comprising the control circuit (21) and the sensors (6).

2. Measurement device according to Claim 1, **characterized in that** the circuit (10) controls all the sensors (6), recovers the data originating from the latter and sends them to tracks (23).

3. Measurement device according to Claim 2, **characterized in that** the circuit (10) is crossed by tracks (23) joining the linking ends (22) of the circuit (10) .

4. Measurement device according to Claim 3, **characterized in that** the sensors (6) are positioned on one and the same row or several rows offset with respect to the tracks (23) .

5. Measurement device according to one of Claims 1 to 4, **characterized in that** tracks (26) are provided to link each of the sensors (6) to the control circuit (21).

6. Measurement device according to one of Claims 1 to 5, **characterized in that** the circuit (10) comprises at least two printed circuit layers separated by an insulating layer.

7. Measurement device according to Claims 2, 5 and 6, **characterized in that** the tracks (23) and (26) are located on one or other of the printed circuit layers.

8. Measurement device according to one of Claims 2 to 4, **characterized in that** one of the tracks (23) is reserved for the power supply for the sensors (6).

9. Measurement system comprising at least one measurement device according to one of Claims 1 to 8, **characterized in that** it comprises a central power supply and acquisition unit (3) connected to the flexible printed circuit (10) of said measurement device, said unit (3) comprising a control circuit (32) for all of the control circuits (21) of the measurement devices.

10. Measurement system according to Claim 9, **characterized in that** the circuit (21) sends data to the unit (3) or to another measurement device.
